Europäisches Patentamt

European Patent Office

Office européen des brevets

(19)

(11) **EP 1 666 893 A1**

(12) **EUROPÄISCHE PATENTANMELDUNG**

(43) Veröffentlichungstag:
   **07.06.2006 Patentblatt 2006/23**

(51) Int Cl.:
   **G01R 15/18** *(2006.01)*

(21) Anmeldenummer: **04028772.4**

(22) Anmeldetag: **04.12.2004**

(84) Benannte Vertragsstaaten:
   **AT BE BG CH CY CZ DE DK EE ES FI FR GB GR HU IE IS IT LI LT LU MC NL PL PT RO SE SI SK TR**
   Benannte Erstreckungsstaaten:
   **AL BA HR LV MK YU**

(71) Anmelder: **Landis+Gyr AG**
   **6300 Zug (CH)**

(72) Erfinder:
   • **Pfaff, Dirk, Dr.**
     **Kanata**
     **Ontario (CA)**

   • **Petr, Jan**
     **6317 Oberwil (CH)**
   • **Hodel, Peter**
     **6300 Zug (CH)**
   • **Schaller, Michel**
     **6340 Baar (CH)**

(74) Vertreter: **Lagler, Louis**
   **Rentsch & Partner**
   **Postfach 2441**
   **8022 Zürich (CH)**

(54) **Integrierte Vorrichtung zur Messung eines Wechselstroms**

(57)   Bei einer integrierten Vorrichtung zur Messung von Wechselstrom nach dem Induktionsprinzip wird diese Vorrichtung einem Magnetfeld (B) ausgesetzt, dass durch einen Wechselstrom erzeugt. Dabei ist eine Spulenanordnung (2a-f) zur Erfassung des Magnetfeldes (B) als integrierter Bestandteil eines Halbleiter-Chips (1) ausgebildet.

Fig. 1a

EP 1 666 893 A1

Fig. 1b

## EP 1 666 893 A1

### Beschreibung

Die Erfindung stammt aus dem technischen Gebiet der elektrischen Strommessgeräte. Sie betrifft eine integrierte Vorrichtung zur Messung eines Wechselstroms, wie sie beispielsweise in elektrischen Stromzählern zur Anwendung gelangen.

Integrierte Vorrichtungen zur Messung von Wechselströmen sind beispielsweise bekannt aus der EP 710 844 B1. Dieses Dokument beschreibt die Verwendung spezieller Spulenanordnungen in Form eines so genannten Gradiometers mit einer in unmittelbarer Nähe zu dessen Ausgängen angeordneten Vorverstärkungseinheit. Ziel dabei ist es, ein durch einen zu messenden Strom erzeugtes Magnetfeld mittels des Gradiometers zu erfassen und eine Signalvorverarbeitung direkt am Ausgang des Gradiometers vorzunehmen. Die durch dieses Gradiometer bereit gestellten Messsignale können somit ohne Störungen durch externe Felder von der Vorverstärkereinheit übernommen und vorverarbeitet werden. Die kurzen Wege zwischen Messsignalerfassung und einer ersten Vorverstärkung spielen bei meist kleinen Signalpegeln eine wichtige Rolle.

Obwohl diese herkömmliche integrierte Vorrichtung bereits eine hohe Messgenauigkeit mit einer Messvorrichtung mit kleinen geometrischen Abmessungen anstrebt, kann diese Vorrichtung höheren Anforderungen an die Messgenauigkeit nicht vollends gerecht werden. Auch die Baugrösse des Gradiometers mit der integrierten Schaltung erlaubt immer noch eine spürbare Beeinflussung durch äussere Störfelder allein aufgrund der geometrischen Abmessungen.

Ausgehend vom gattungsgemässen Stand der Technik liegt der Erfindung deshalb die Aufgabe zugrunde, eine integrierte Vorrichtung zur Messung eines Wechselstroms bereit zu stellen, die eine vergleichsweise genauere Messung ermöglicht unter der Vorgabe, wesentlich kleinerer geometrischer Abmessungen gegenüber dem Stand der Technik aufzuweisen.

Erfindungsgemäss wird diese Aufgabe durch die Merkmale des Anspruchs 1 gelöst. Weitere vorteilhafte Ausgestaltungen der Erfindung sind Gegenstand der abhängigen Ansprüche 2 bis 5.

Zur Lösung der der Erfindung zugrunde liegenden Aufgabe ist bei einer Vorrichtung zur Messung eines Wechselstroms vorgesehen, eine Spulenanordnung monolithisch als integrierten Bestandteil eine Halbleiter-Chips auszubilden. Auf diese Weise bildet die Spulenanordnung mit dem Halbleiter-Chip eine gemeinsame Einheit, die gesamthaft dem durch einen zu messenden Strom erzeugten Magnetfeld ausgesetzt wird. Das von der Spulenanordnung erfasste Messsignal verbleibt unmittelbar im Halbleiter-Chip, in dem mindestens eine erste, entscheidende Signalverarbeitung stattfindet. Die Zuleitungswege zwischen der messenden Spulenanordnung und einer Signalverarbeitungseinheit im Halbleiter-Chip sind somit vernachlässigbar klein. Ein Einfluss äusserer Störfelder auf die eigentliche Messung ist somit mittels der Erfindung annähernd unbedeutend.

Mit Vorteil ist die Spulenanordnung in einer Schicht des Halbleiter-Chips ausgebildet. Denkbar im Sinne der Erfindung ist auch, dass die Spulenanordnung sich über zwei oder mehr Schichten des Halbleiter-Chips erstreckt.

Vorteilhafterweise ist die Spulenanordnung im wesentlichen an einem äusseren Randbereich, der so genannten Peripherie des Halbleiter-Chips angeordnet. Dadurch umschliesst die Spulenanordnung eine möglichst grosse wirksam durchflutete Fläche, um ein Maximum an induzierter Signalspannung zu erreichen.

Weitere Vorteile der Erfindung ergeben sich aus den Ansprüchen und der folgenden detaillierten Beschreibung, in der bevorzugte Ausgestaltungen unter Bezugnahme auf die schematische Zeichnung im einzelnen erläutert sind. Dabei zeigt:

Fig. 1 a, b eine erfindungsgemässe integrierte Vorrichtung zur Messung von Wechselstrom,

Fig. 2 a, b eine Ausführungsvariante der integrierten Vorrichtung zur Messung von Wechselstrom, und

Fig. 3 a, b eine weitere Ausführungsvariante.

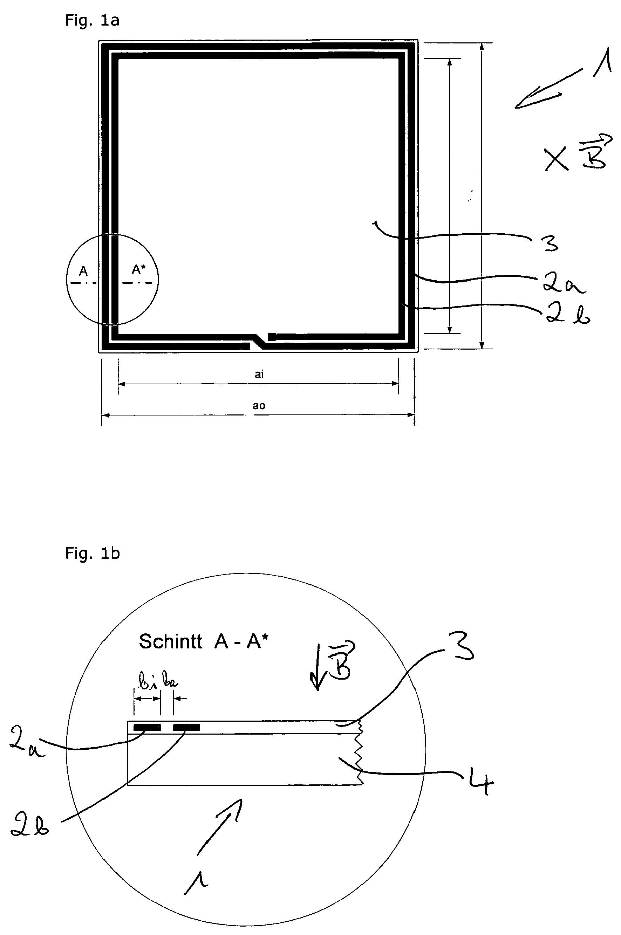

In Fig. 1a und 1b ist mit 1 ein Halbleiter-Chip bezeichnet, der eine Schicht 3 und eine Signalverarbeitung 4 umfasst. Fig. 1b ist hier eine vergrösserte Schnittdarstellung des Schnitts A-A* in Fig. 1a. Entlang eines äusseren Randes, der so genannten Peripherie des Halbleiter-Chips 1, ist innerhalb der Schicht 3 eine Spulenanordnung (2a, 2b) als ein integrierter Bestandteil des Halbleiter-Chips ausgebildet.

Die Spulenanordnung 2a, 2b ist zur Messung eines Magnetfeldes B ausgelegt, wobei dieses Magnetfeld als Abbild eines hier nicht gezeigten Stromflusses in einem ebenfalls nicht dargestellten elektrischen Leiter generiert, zur Messung des Stromes verwendet werden kann.

Die innere Spulenwindung 2b hat eine Länge ai und eine Leiterbreite bi, und die äussere Spulenwindung 2a hat eine Länge ao und ebenfalls eine Leiterbreite bi. Diese Bezeichnungen der Länge und Breite der Spulenwindungen spielt bei einem unten angefügten praktischen Beispiel eine Rolle. Der Abstand zwischen zwei Spulenwindungen ist mit ba bezeichnet.

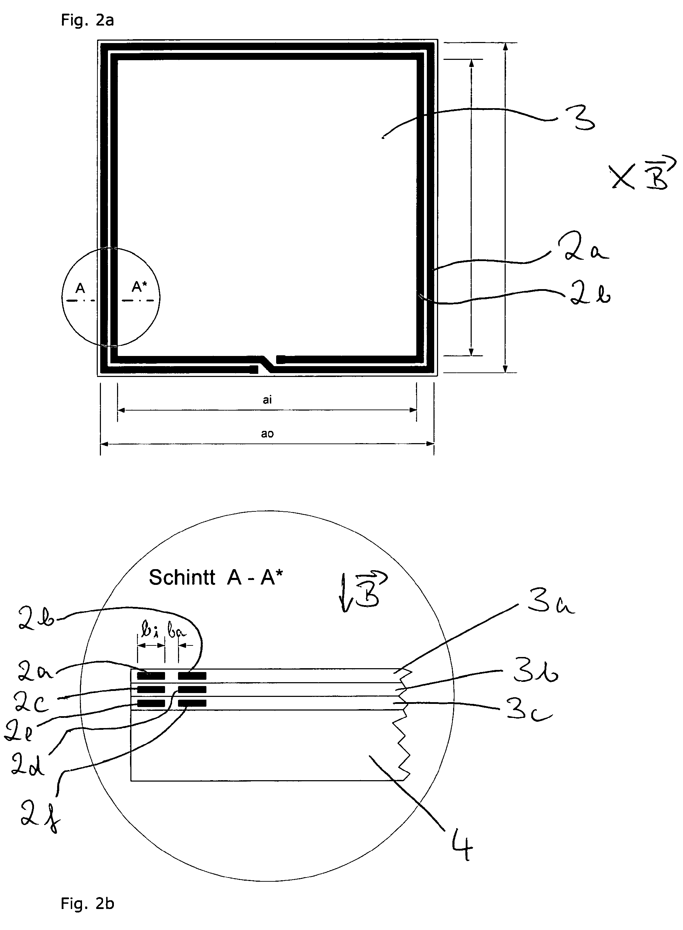

Die Fig. 2a und 2b zeigen -ähnlich wie die Fig. 1a und 1b- eine integrierte Vorrichtung zur induktiven Strommessung mit dem Unterschied, dass sich die Spulenanordnung 2a-f über drei Schichten 3a, 3b, 3c des Halbleiter-Chips 1 erstreckt, wie Fig. 2b erhellt.

Die beispielhaft gezeigten integrierten Vorrichtungen zur Strommessung sind besonders geeignet für die Strommessung in elektronischen Zählern zur Erfassung bezogener Energieeinheiten. Die besonders kompakte Bauweise des Halbleiter-Chips 1 mit einer monolithisch aufgebauten Struktur, umfassend eine oder mehrere Schichten 3a, 3b, 3c mit einer Spulenanordnung 2a-f und einer Signalverarbeitung 4 ermöglicht zum einen die geometrischen Abmessungen im Vergleich zum Stand der Technik wesentlich zu Verkleinern und zum anderen sind die nicht explizit dargestellten Verbindungsleitungen zwischen einer Spulenanordnung 2a-f und der Signalverarbeitung 4 derart klein, dass ein äusserer Störeinfluss unbedeutend klein ist. Die Wirkverbindung zwischen der Spulenanordnung 2a-f und der Signalverarbeitung 4 ist quasi unbeeinflussbar gegenüber von aussen wirkenden Feldern.

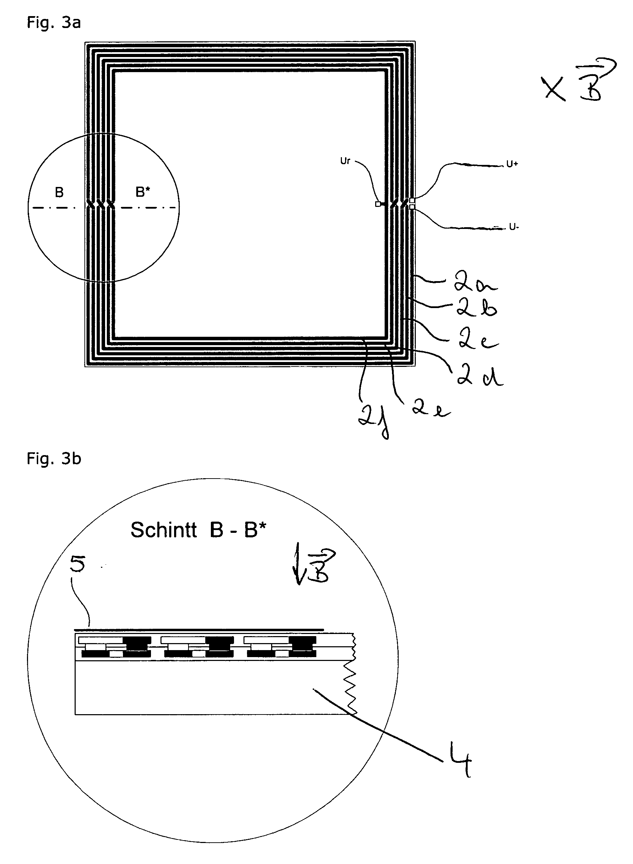

In Fig. 3a ist eine Ausführungsvariante der Erfindung dargestellt, bei der die Spulenwindungen 2a-f so miteinander an einer Schnittstelle B-B* miteinander verschaltet sind, dass sich eine Anschlussstelle einer Referenzspannung Ur mit einem Referenzpotential ausbildet und symmetrisch zu dieser Referenzspannung eine Spannungsabgriff U+ und ein Spannungsabgriff U-ausbildet. Diese Spannungsabgriffe U+ und U- sind symmetrisch zueinander betragsmässig gleich gross. Mit Vorteil lassen sich zwecks Messfehlerbehebung diese Spannungen U+ und U- zueinander addieren und/oder subtrahieren.

Ein praktisches Ausführungsbeispiel mit geometrischen und elektrischen Rahmenbedingungen und den Anforderungen an die Signalverarbeitung 4 sieht wie folgt aus:

Praktisches Beispiel

1. Geometrische Parameter der Spule

| | | |
|---|---|---|
| Kantenlänge innen | | $a_i := 1.90 \cdot$ mm |
| Kantenlänge aussen | | $a_a := 2.00 \cdot$ mm |
| Kantenlänge effektiv | $a_e := \sqrt{\dfrac{a_i^2 + a_a^2}{2}}$ | $a_e = 1.951$mm |
| Fläche der Spule | $A_s := a_a^2 - a_i^2$ | $A_s = 0.390$mm$^2$ |
| Fläche des Spulenfensters | $A_f := a_i^2$ | $A_f = 3.610$mm$^2$ |
| Fläche der Spule relativ zum Fenster (massgebend für die Kosten der Spule) | $\alpha := \dfrac{A_s}{A_f}$ | $\alpha = 10.803\%$ |
| Leiterbahn Breite | | $b_l := 1.5 \cdot \mu$m |
| Leiterbahn Abstand | | $b_a := 0.5 \cdot \mu$m |
| Anzahl Windungen | | $N := 50$ |

2. Elektrische Parameter der Spule

Mit

- Frequenz des Eingangsignals 50Hz umgerechnet in rad/s   $\omega := 314.16 \cdot \dfrac{\text{rad}}{\text{s}}$

- Induktion des Eingangsignals bei Volllast (Maximallast) $B_m := 40 \cdot$ mT

- Flächenwiderstand der Spulenwicklung $r := 0.08 \cdot \Omega$

Ist

- der Widerstand der Spulenwicklung

$$R_c := 2 \cdot r \cdot \frac{(a_i + a_a)}{b_l} \cdot N$$

$$R_c = 20.8 \text{k}\Omega$$

- Rauschspannungsdichte des Spulenwiderstandes

$$u_{nc} := 1.28 \cdot 10^{-10} \cdot \sqrt{R_c} \cdot \frac{V}{\sqrt{Hz \cdot \Omega}}$$

$$u_{nc} = 18.46 \frac{nV}{\sqrt{Hz}}$$

- Signalspannung der Spule bei maximaler Induktion $B = B_m$

$$U_m := \omega \cdot a_e^2 \cdot N \cdot B_m$$

$$U_m = 2.391 mV$$

3. Anforderungen an die Signalverarbeitung

Für die Signalverarbeitung der Spule sind in diesem Zusammenhang zwei wichtige Parameter Vorgegeben:

- Maximal zulässiger DC Offset der Signalverarbeitung $U_0$ kleiner als 25% des Wertes der maximalen Signalspannung Um

- Minimalwert des Signal / Rauschsdichte Verhältnisses des Gesamtsystems bei Volllast $\sigma_{sm}$

$$\sigma_{sm} := 52.4 \cdot 10^3 \cdot \sqrt{Hz}$$

Mit den oben aufgeführten elektrischen Parametern der Spule lassen sich die Anforderungen an die Signalverarbeitung wie folgt konkretisieren:

- Maximale DC Offset der Signalverarbeitung

$$U_{0max} := 0.25 \cdot U_m$$

$$U_{0max} = 0.598 mV$$

$$u_n := \frac{U_m}{\sigma_{sm}}$$

$$u_n = 45.625 \frac{nV}{\sqrt{Hz}}$$

- Maximal zulässige Rauschspannungsdichte der Signalverarbeitung $u_{na}$ aus der Rauschspannungsdichte des Gesamtsystems $u_n$ unter Abzug der Rauschspannungsdichte des Spulenwiderstandes $u_{nc}$

$$u_{na} := \sqrt{u_n^2 - u_{nc}^2}$$

$$u_{na} = 41.724 \frac{nV}{\sqrt{Hz}}$$

Die zuletzt angegebenen Parameter der Signalverarbeitung lassen sich mit einer entsprechend optimierter Schaltung problemlos realisieren.

Bezugszeichenliste

| | |
|---|---|
| 1 | Halbleiter-Chip |
| 2a-f | Spulenanordnung |
| 3a-c | Schichten ein |
| 4 | Signalverarbeitung |
| 5 | leitende Schicht |
| ai | Spulenwindungslänge |
| ao | Spulenwindungslänge |
| bi | Spulenwindungsbreite |
| bo | Spulenwindungsbreite |
| ci | Leiterbreite einer Spulenwindung |
| co | Leiterabstand |
| U+ | Spannungsabgriff |
| U- | Spannungsabgriff |
| Ur | Referenzspannung |
| B | Magnetfeld |

**Patentansprüche**

1. Integrierte Vorrichtung zur Messung eines Wechselstroms nach dem Induktionsprinzip, wobei diese Vorrichtung einem Magnetfeld (B) ausgesetzt ist, welches durch den Wechselstrom erzeugt wird,
   **dadurch gekennzeichnet,**
   **dass** eine Spulenanordnung (2a-f) zur Erfassung des Magnetfeldes (B) als ein integrierter Bestandteil eines Halbleiter-Chips (1) ausgebildet ist.

2. Integrierte Vorrichtung nach Anspruch 1,
   **dadurch gekennzeichnet,**
   **dass** die Spulenanordnung (2a-f) innerhalb einer Schicht (2) oder mehren Schichten (3a-c) des Halbleiter-Chips (1) ausgebildet ist.

3. Integrierte Vorrichtung nach einem der vorherigen Ansprüche,
   **dadurch gekennzeichnet,**
   **dass** der Halbleiter-Chip (1) zumindest einen Teil einer Signalverarbeitungseinrichtung (4) umfasst, die mit der Spulenanordnung (2a-f) in Wirkverbindung steht.

4. Integrierte Vorrichtung nach einem der vorhergehenden Ansprüche,
   **dadurch gekennzeichnet,**
   **dass** die Spulenanordnung (2a-f) im wesentlichen an einem äusseren Randbereich (Peripherie) des Halbleiter-Chips (1) angeordnet ist.

5. Integrierte Vorrichtung nach einem der vorhergehenden Ansprüche,

**dadurch gekennzeichnet,**
**dass** die Spulenanordnung (2a-f) als mindestens eine Planarspule ausgebildet ist.

6. Integrierte Schaltung nach einem der vorhergehenden Ansprüche,
**dadurch gekennzeichnet,**
**dass** die mittels mindestens einer leitenden Schicht (5) zumindest der Bereich der Spulenanordnung (2a-f) abgeschirmt ist.

7. Integrierte Schaltung nach einem der vorhergehenden Ansprüche,
**dadurch gekennzeichnet,**
**dass** ein Mittelpunkt der Spulenanordnung (2a-f) als Referenzspannung Ur ausgebildet ist, und symmetrisch dazu ein positiver Spannungsabgriff U+ und ein negativer Spannungsabgriff U- an den Enden der Spulenanordnung (2a-f) ausgebildet ist.

Fig. 1a

Fig. 1b

Schintt A - A*

Fig. 2a

Fig. 2b

Fig. 3a

Fig. 3b

**Europäisches Patentamt**

# EUROPÄISCHER RECHERCHENBERICHT

**Nummer der Anmeldung**

EP 04 02 8772

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X <br><br> Y | US 6 452 413 B1 (BURGHARTZ JOACHIM NORBERT) 17. September 2002 (2002-09-17) <br> * Spalte 1, Zeile 8 - Spalte 4, Zeile 63; Abbildungen 1,4-7 * <br> * Spalte 6, Zeile 63 - Spalte 7, Zeile 14 * <br><br> * Spalte 6, Zeile 35 - Zeile 42 * <br> ----- | 1-5 <br><br> 6 | G01R15/18 |
| X | US 5 963 038 A (DE JONG ET AL) 5. Oktober 1999 (1999-10-05) <br> * Spalte 5, Zeile 26 - Zeile 49; Abbildungen 1,2 * <br> * Spalte 4, Zeile 1 - Spalte 5, Zeile 25 * <br> ----- | 1,2,5,7 | |
| X | US 5 884 990 A (BURGHARTZ ET AL) 23. März 1999 (1999-03-23) <br> * Spalte 2, Zeile 44 - Spalte 4, Zeile 34; Abbildung 1 * <br> ----- | 1,4,5 | |
| Y | US 5 831 426 A (BLACK, JR. ET AL) 3. November 1998 (1998-11-03) <br> * Spalte 7, Zeile 26 - Zeile 67; Abbildung 2B * <br> ----- | 6 | **RECHERCHIERTE SACHGEBIETE (Int.Cl.7)** <br><br> G01R |
| A | EP 0 710 844 A (ENERMET OY) 8. Mai 1996 (1996-05-08) * das ganze Dokument * <br> ----- | 1-7 | |

Der vorliegende Recherchenbericht wurde für alle Patentansprüche erstellt

| Recherchenort | Abschlußdatum der Recherche | Prüfer |
|---|---|---|
| Den Haag | 4. Mai 2005 | Koll, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 04 02 8772

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-05-2005

| Im Recherchenbericht angeführtes Patentdokument | Datum der Veröffentlichung | Mitglied(er) der Patentfamilie | Datum der Veröffentlichung |
|---|---|---|---|
| US 6452413 B1 | 17-09-2002 | US 6177806 B1 | 23-01-2001 |
| US 5963038 A | 05-10-1999 | EP 0843824 A1 | 27-05-1998 |
| | | WO 9746891 A1 | 11-12-1997 |
| | | JP 11510906 T | 21-09-1999 |
| | | US 5894224 A | 13-04-1999 |
| US 5884990 A | 23-03-1999 | US 5793272 A | 11-08-1998 |
| | | US 6054329 A | 25-04-2000 |
| | | US 6114937 A | 05-09-2000 |
| US 5831426 A | 03-11-1998 | AU 3892697 A | 06-03-1998 |
| | | CA 2261312 A1 | 19-02-1998 |
| | | CN 1251171 A | 19-04-2000 |
| | | EP 0979419 A2 | 16-02-2000 |
| | | JP 2000516714 T | 12-12-2000 |
| | | KR 2000029928 A | 25-05-2000 |
| | | WO 9807165 A2 | 19-02-1998 |
| | | US 6252390 B1 | 26-06-2001 |
| EP 0710844 A | 08-05-1996 | FI 945232 A | 08-05-1996 |
| | | AT 217976 T | 15-06-2002 |
| | | DE 69526774 D1 | 27-06-2002 |
| | | DE 69526774 T2 | 21-11-2002 |
| | | DK 710844 T3 | 26-08-2002 |
| | | EP 0710844 A2 | 08-05-1996 |
| | | ES 2177597 T3 | 16-12-2002 |

EPO FORM P0461

Für nähere Einzelheiten zu diesem Anhang : siehe Amtsblatt des Europäischen Patentamts, Nr.12/82